# EUROPEAN PATENT APPLICATION

(11) **EP 1 170 774 A1**
(43) Date of publication of application: **09.01.2002**
(21) Application number: 00915461.8
(22) Date of filing: 10.04.2000
(51) Int. Cl.: H01J 37/317, H01L 21/265

(54) **METHOD AND APPARATUS FOR ION IMPLANTATION**

(30) Priority: 09.04.1999 JP 10254299
(71) Applicant: Applied Materials, Inc., Santa Clara, California 95054 (US)
(72) Inventor: TAKADA, Koichi Applied Materials Japan, Inc., Narita-shi Chiba 286-8516 (JP); MIURA, Ryuichi Applied Materials Japan, Inc., Narita-shi Chiba 286-8516 (JP); MATSUNAGA, Yasuhiko Applied Materials Japan, Inc., Narita-shi Chiba 286-8516 (JP)
(74) Representative: Cross, Rupert Edward Blount
(86) International application number: JP0002324
(87) International publication number: WO0062325

(57) **Abstract**

For carrying out ion implantation in wafers, a wafer transfer robot picks up a wafer from a wafer storage cassette and mounts it on a surface of an elastic sheet of each wafer holder. After completion of ion implantation, the wafer transfer robot dismounts the wafer from each wafer holder and returns it into the wafer storage cassette. When in the load lock chamber there is no wafer storage cassette storing new wafers to be subsequently subjected to ion implantation, the wafer transfer robot picks up a dummy wafer from another wafer storage cassette and mount it on the surface of the elastic sheet of each wafer holder. This decreases contaminants attaching to the surface of the elastic sheet.

## Description

### Technical Field

The present invention relates to an ion implantation method and ion implantation apparatus for directing an ion beam to a wafer to implant ions therein.

### Background Art

In general, an ion implantation apparatus is provided with an ion beam generating section for generating an ion beam, an ion implantation section for directing the ion beam from the ion beam generating section toward a silicon wafer to be processed to implant ions therein, and a wafer loader section for loading wafers into the ion implantation section.

The ion implantation section has a target chamber under vacuum inside, in which a wafer supporting unit is placed. The wafer supporting unit is equipped, for example, with a swing shaft arranged swingablely and the swing shaft is provided with a rotatable hub, from which a plurality of arms extend radially. A wafer holder for holding a wafer is provided at the distal end of each arm. The wafer loader section has a load lock chamber under vacuum inside, and a wafer transfer robot for picking up a wafer stored in a wafer storage cassette and transferring the wafer to the position of the wafer holder is located in the load lock chamber.

In such an ion implantation apparatus, since the ion implantation into the wafer heats the wafer to high temperatures, the wafer held on the surface of the wafer holder is commonly cooled by providing the wafer holder with a cooling water path and letting cooling water flow in the cooling water path.

During execution of the ion implantation process by the above-mentioned ion implantation apparatus, the ion beam from the ion beam generating section is not injected only into the wafer, but is also injected into a beam stop and the like in the target chamber. The ions impinging upon the other portions than the wafer may bring about sputtering and cause contamination.

Since some time is necessary for adjustment of traveling direction of the ion beam and the like at start-up of the ion beam, it is often the case that once the ion beam is started up, the ion beam is kept on radiating even during a period after completion of an ion implantation process and before a start of a next ion implantation process. In this case, however, since the surface of the wafer holder is in an exposed state, particles, atoms, molecules, etc. evolved by the sputtering or the like with the ion beam may be deposited on the surface of the wafer holder. If in this condition, a wafer is mounted on the surface of the wafer holder to perform ion implantation, a clearance will be present between the back surface of the wafer and the surface of the wafer holder, so as to fail to yield satisfactory, thermal conductivity between them. As a result, wafer cooling efficiency with the cooling water will be degraded.

This disadvantage appears prominent, particularly, upon exchange of wafer storage cassettes. The reason is that after the interior of the load lock chamber is exposed to the atmosphere, it has to be decompressed to a desired vacuum and in this case the surface of the wafer holder is exposed to the beam for a longer time.

An object of the present invention is to provide an ion implantation method and apparatus that can reduce contaminants on the wafer holder and improve the wafer cooling efficiency.

### Disclosure of the Invention

For accomplishing the above object, the present invention provides an ion implantation method of radiating ions to each of wafers held on a plurality of respective wafer holders to implement ion implantation therein, wherein during a period between an ion implantation process and a next ion implantation process, when the ion radiation is kept on and when at least one of the plurality of wafer holders holds no wafer, said at least one wafer holder holds a dummy wafer thereon.

Since the wafer holder is made to hold the dummy wafer in this way, the above method largely decreases the time in which the surface of the wafer holder is in the exposed state. This decreases contaminants attaching to the surface of the wafer holder. Thus, when the wafer holder is made to hold a wafer to be processed in a next ion implantation process, the back surface of the wafer can be brought into contact with the surface of the wafer holder throughout its almost entire surface. This yields satisfactory, thermal conductivity between the wafer and the wafer holder, which increases the wafer cooling efficiency with cooling water.

The above ion implantation method preferably comprises a first step of making the wafer holders hold the wafers, a second step of implementing the ion implantation in the wafers held on the wafer holders, and a third step of, after completion of the ion implantation in the wafers, dismounting the wafers from the wafer holders, the first to third steps being carried out repeatedly while maintaining the ion radiation, wherein the wafer holders are made to hold dummy wafers during a period between the third step and the first step. This largely decreases the time in which the surfaces of the wafer holders are in the exposed state, during the period between the third step and the first step, thereby enhancing the wafer cooling efficiency as described above.

Preferably, the method comprises a first step of making the wafer holders hold the wafers, a second step of implementing the ion implantation in the wafers held on the wafer holders, and a third step of, after completion of the ion implantation in the wafers, dismounting the wafers from the wafer holders, the first to third steps being carried out repeatedly while maintaining the ion radiation, wherein after the third step, if there is a wafer to be subsequently subjected to ion implantation the wafer is made to be held on the wafer holder, or if there is no wafer to be subjected to ion implantation the dummy wafer is made to be held on the wafer holder. In this method, if there is a wafer to be subsequently subjected to ion implantation, the wafer is immediately made to be held on the wafer holder, which ensures execution of an efficient ion implantation process.

For accomplishing the above object, the present invention provides an ion implantation apparatus comprising: a target chamber under vacuum inside; a wafer holder placed in the target chamber; ion beam generating means for generating an ion beam to be radiated to a wafer held on the wafer holder; a load lock chamber placed adjacent to the target chamber and kept under vacuum inside; wafer transfer means disposed in the load lock chamber; and control means for controlling the wafer transfer means so as to make the wafer holder hold the wafer before the ion beam generated by the ion beam generating means is radiated to the wafer to implement ion implantation therein, and for controlling the wafer transfer means so as to dismount the wafer from the wafer holder after completion of the ion implantation in the wafer, wherein the control means controls the wafer transfer means so as to make the wafer holder hold a dummy wafer during a period after the wafer is dismounted from the wafer holder and before a new wafer is held on the wafer holder.

By configuring the control means in this way, the apparatus can carry out the above ion implantation method and thus decrease the contaminants attaching to the wafer holders, thereby enhancing the wafer cooling efficiency.

In the above ion implantation apparatus, preferably, the control means monitors whether a wafer to be subsequently subjected to ion implantation is present in the load lock chamber after the wafer is dismounted from the wafer holder; when it is determined that the wafer to be subjected to ion implantation is present, the control means controls the wafer transfer means so as to make the wafer holder hold the wafer; and when it is determined that the wafer to be subjected to ion implantation is absent, the control means controls the wafer transfer means so as to make the wafer holder hold the dummy wafer. In this structure, when there is a wafer to be subsequently subjected to ion implantation, the wafer is immediately made to be held on the wafer holder, which ensures execution of an efficient ion implantation process.

For accomplishing the above object, the present invention further provides an ion implantation apparatus for radiating ions to each of wafers held on a plurality of respective wafer holders to implement ion implantation therein, wherein during a period between an ion implantation process and a next ion implantation process, when the ion radiation is kept on and when at least one of the wafer holders holds no wafer, the wafer holder is made to support a dummy wafer. This permits the apparatus to carry out the above ion implantation method and thus improves the wafer cooling efficiency as described above.

The above and other features and advantages of the present invention will become apparent to those skilled in the art from the detailed description with reference to the accompanying drawings, which follows.

### Brief Description of the Drawings

Fig. 1 is a schematic view showing an embodiment of the ion implantation apparatus according to the present invention.
Fig. 2 is a perspective view of the ion implantation apparatus shown in Fig. 1.
Fig. 3 is a plan view of an arm of a wafer supporting unit shown in Fig. 1.
Fig. 4 is a cross-sectional view along line IV-IV of Fig. 3.
Fig. 5 is a flowchart showing procedures of the ion implantation process carried out by a control unit shown in Fig. 1.

### Best Mode for Carrying out the Invention

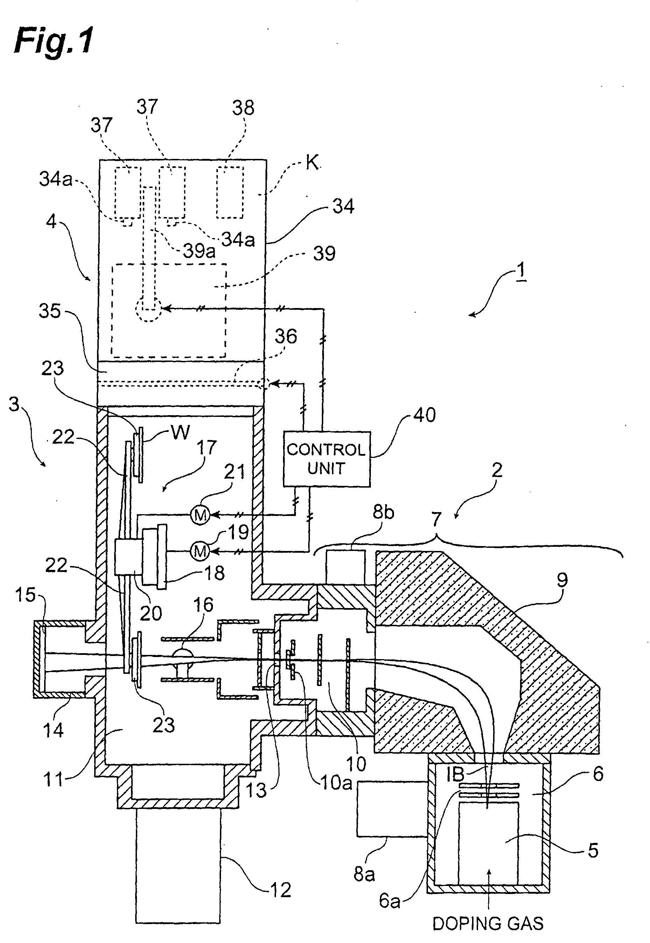

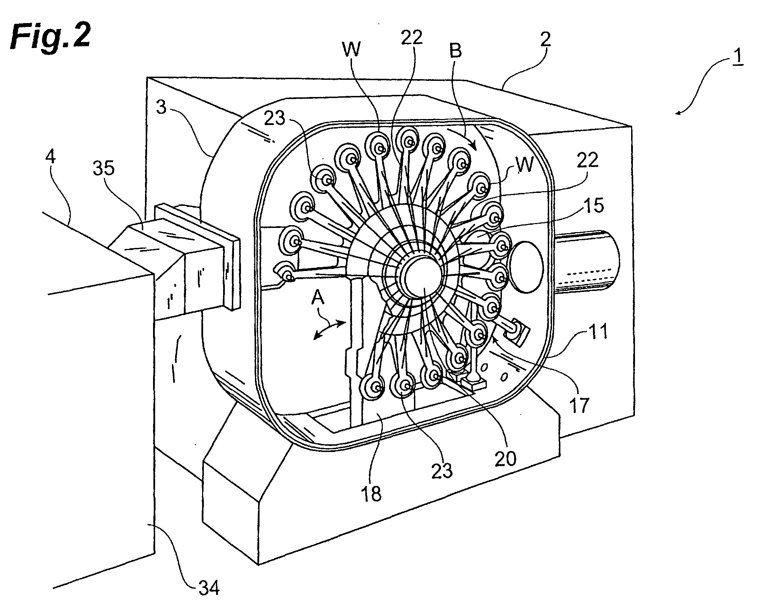

The preferred embodiments of the present invention will be described below in detail with reference to the accompanying drawings. Fig. 1 is a structural diagram schematically showing an embodiment of the ion implantation apparatus according to the present invention and Fig. 2 is a perspective view of the ion implantation apparatus. In the figures, the ion implantation apparatus 1 is provided with an ion beam generating section 2 for generating an ion beam IB, an ion implantation section 3 for directing the ion beam IB from the ion beam generating section 2 toward a silicon wafer W to implement ion implantation therein, and a wafer loader section 4 for loading wafers W to the ion implantation section 3.

The ion beam generating section 2 is comprised of an ion source 5, an ion beam extraction-acceleration system 6, and a mass spectrometric system 7. Each of the systems is surrounded by a housing or a tube and the inside thereof is decompressed to a predetermined vacuum by vacuum pumps 8a, 8b.

The ion source 5 induces electric discharge in doping gas supplied from a gas supply (not shown), to create a plasma state of high density. The ion beam extraction-acceleration system 6 has a pair of extraction electrodes 6a and a negative voltage is applied between the extraction electrodes 6a to extract ions from the plasma and accelerate them, thereby forming the ion beam IB. The mass spectrometric system 7 is comprised of an analyzing magnet section 9 and a mass resolving section 10. The analyzing magnet section 9 can control the magnetic field strength to extract only a desired ion species from the above-mentioned ion beam IB. The mass resolving section 10 has an open/close mechanism 10a the aperture width of which is adjustable, and lets only the desired ion beam to pass.

The ion implantation section 3 is provided with a target chamber 11 connected to the mass resolving section 10 of the mass spectrometric system 7, and the interior of this target chamber 11 is decompressed to a desired vacuum by cryopump 12.

In the wall portion defining the target chamber 11, an aperture portion 13 for entrance of the ion beam IB is formed at a junction to the mass spectrometric system 7 and a Faraday box 14 is mounted at a portion opposite to the aperture portion 13. A beam stop 15 for receiving the ion beam IB is disposed in the Faraday box 14. The beam stop 15 has an ion detector (not shown) for detecting a dose of the ion beam. A plasma shower 16 is located at the position where the ion beam IB passes in the target chamber 11. The plasma shower 16 functions to prevent charge-up of wafer W when the ion beam IB is injected into the wafer W.

A wafer supporting unit 17 for supporting wafers W to be subjected to ion implantation is disposed in the target chamber 11. The wafer supporting unit 17 has a swing shaft 18 which is swingably mounted in the target chamber 11. The swing shaft 18 can be swung within a predetermined angle range along directions of arrows A in Fig. 2 by a driving motor 19. A hub 20 is rotatably mounted at the distal end of the swing shaft 18. The hub 20 is rotationally driven in the direction of arrow B in Fig. 2 by a driving motor 21. A plurality of arms 22 extend radially from the hub 20 and a wafer holder 23 for holding a wafer W is provided at the distal end of each arm 22.

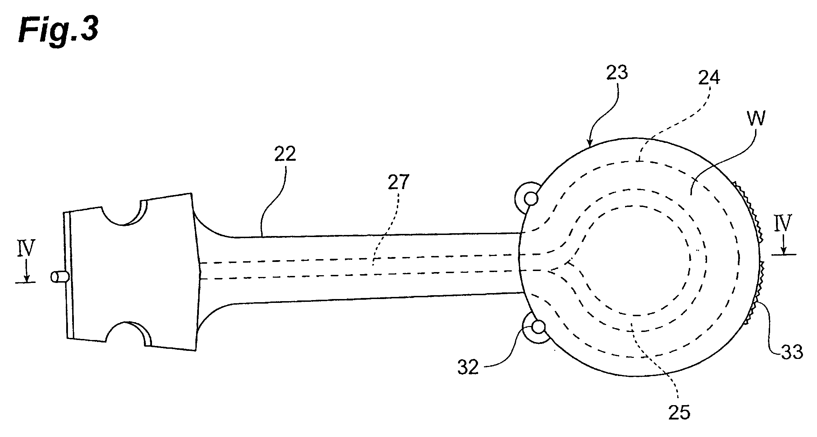

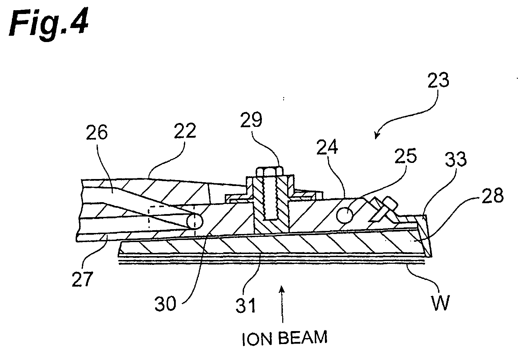

The detailed views of the wafer holder 23 are shown in Fig. 3 and Fig. 4. In these figures, the wafer holder 23 has a circular heat sink paddle 24 mounted at the distal end of arm 22 and a cooling water path 25 is formed in the heat sink paddle 24. The cooling water path 25 is in communication with a supply conduit 26 and a return conduit 27 which are formed in the arm 22 between the base end and the distal end thereof.

A circular heat sink insert 28 of metal is fixed on the surface of the heat sink paddle 24 with fixture 29. A thermally conductive and elastic sheet 30 is placed between the heat sink paddle 24 and the heat sink insert 28, so as to yield high thermal conductivity between the two members 24 and 28. A thermally conductive and elastic sheet 31 is attached on the surface of the heat sink insert 28, and a wafer W is mounted on the surface of the elastic sheet 31. This achieves high thermal conductivity between the heat sink insert 28 and the wafer W when the wafer W rests on the surface of the elastic sheet 31. The heat sink paddle 24 is provided with wafer restraint 33 and stopper 32 having a spring (not shown). The wafer restraint 33 and stopper 32 can keep the wafer W from slipping off the elastic sheet 31, when the wafer W rests on the surface of the elastic sheet 31.

Now referring back to Fig. 1 and Fig. 2, the wafer loader section 4 has a load lock chamber 34 located adjacent to the target chamber 11, and the interior of the load lock chamber 34 is decompressed to a vacuum by an unrepresented vacuum pump. A transfer passage 35 is formed between the load lock chamber 34 and the target chamber 11, and an isolation valve 36 is interposed in the transfer passage 35 to isolate the load lock chamber 34 from the target chamber 11.

Inside the load lock chamber 34 there is provided a cassette mount section K on which wafer storage cassettes 37, 38 are mount. A wafer storage cassette 37 is a cassette for accommodating and storing a plurality of wafers W to be subjected to ion implantation, and a plurality of (e.g., two) cassettes are mounted on the cassette mount K. A wafer storage cassette 38 is a cassette for housing and storing a plurality of dummy wafers Wd (dummy wafer storing means). The "dummy wafer Wd" herein is a wafer for protecting the surface of the elastic sheet 31 of the wafer holder 23 during periods except for periods of ion implantation, which has the shape and weight similar to those of the wafers W to be subjected to ion implantation. The dummy wafer does not always have to be limited to the same as the wafers W to be subjected to ion implantation, but may be any thing that can protect the surface of the elastic sheet 31. However, use of the same as the wafers W to be subjected to ion implantation eliminates the need for fabrication of extra dummy wafers.

The cassette mount K is provided with cassette detecting sensors 34a and the cassette sensors 34a monitor whether the wafer storage cassettes 37 with wafers W to be subjected to ion implantation are located at predetermined positions.

In the load lock chamber 34 there is provided a wafer transfer robot 39 for transferring a wafer W to the position of each wafer holder 23 in the wafer supporting unit 17. The wafer transfer robot 39 is provided with a carry arm 39a which can be rotated and slid by a plurality of actuators (not shown). Controlling this carry arm 39a, the robot 39 can pick up a wafer W in the wafer storage cassette 37, 38, mount the wafer W on the surface of the elastic sheet 31 of the wafer holder 23, dismount a wafer W from the elastic sheet 31 and return it into the cassette 37, 38.

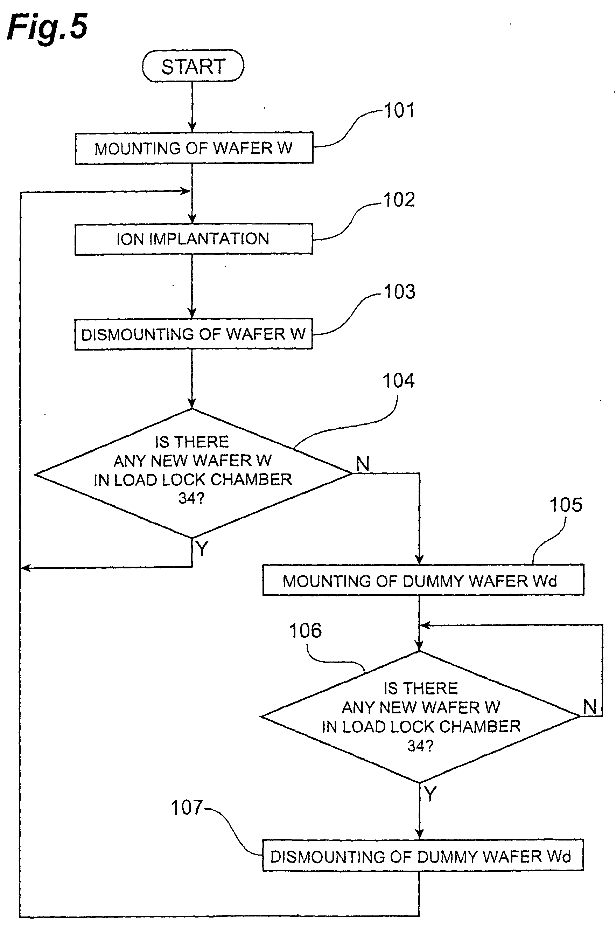

The driving motors 19, 21 of the wafer supporting unit 17, the isolation valve 36, and the actuators of the wafer transfer robot 39 are driven by control signals from a control unit 40. The ion implantation procedures by this control unit 40 are presented in Fig. 5. The flowchart of Fig. 5 is based on the premise that the start-up and adjustment of the ion beam IB by the ion beam generating section 2 have already been accomplished.

First, in response to an instruction to start the ion implantation operation through an instruction switch or the like (not shown), the control unit controls the isolation valve 36 to open it, and sends a wafer load signal to each actuator of the wafer transfer robot 39 to mount a wafer W, which is stored in the wafer storage cassette 37, on the surface of wafer holder 23 (step 101). At this time, the wafer supporting unit 17 is located at a wafer mounting position where the ion beam IB does not impinge on the wafer holders 23, and the control unit controls the wafer transfer robot 39 and also controls the driving motor 21 to rotate the wafer supporting unit 17, thereby successively mounting the wafers W on the surfaces of respective wafer holders 23.

When it is then determined that the wafers W are mounted on all the wafer holders 23, for example, based on a signal from a sensor (not shown) provided in the target chamber 11, the control unit controls the isolation valve 36 to close it and also controls the driving motors 19, 21 to rotate the wafer supporting unit 17 at a constant, high speed and swing it from the wafer mounting position, and then the control unit initiates ion implantation (step 102).

When it is then determined that the ion implantation has been completed for all the wafers W, based on a signal from the ion detector in the beam stop 15 and a time measured by an internal timer, the control unit controls the driving motor 19 to move the wafer supporting unit 17 to the wafer mounting position and also controls the isolation valve 36 to open it. Then, the control unit sends a wafer unload signal to each actuator of the wafer transfer robot 39 to dismount the wafers W from the respective wafer holders 23 and return them into the wafer storage cassette 37 (step 103).

It is then determined whether a wafer storage cassette 37 accommodating new wafers W to be subsequently subjected to ion implantation is placed at the predetermined position on the cassette mount K, based on signals from the cassette sensors 34a (step 104). When it is determined that such a wafer storage cassette 37 is present, the control unit proceeds to aforementioned step 101. When it is determined on the other hand that such a wafer storage cassette 37 is absent, the control unit outputs a dummy wafer load signal to each actuator of the wafer transfer robot 39 to mount dummy wafers Wd stored in the wafer storage cassette 38 on the surfaces of the respective wafer holders 23 (step 105). After that, the control unit controls the isolation valve 36 to close it.

It is then determined whether a wafer storage cassette 37 with new wafers W to be subsequently subjected to ion implantation is present at the predetermined position on the cassette mount K, from detection signals of the cassette sensors 34a (step 106). When it is determined that such a wafer storage cassette 37 is present, the control unit controls the isolation valve 36 to open it and also sends a dummy wafer unload signal to each actuator of the wafer transfer robot 39 to dismount the dummy wafers Wd from the respective wafer holders 23 and return them into the wafer storage cassette 38 (step 107). After that, the processes at and after aforementioned step 101 are executed.

Described below is an ion implantation method according to the present invention, using the ion implantation apparatus 1 constructed as described above.

First, the isolation valve 36 is opened and the transfer arm 39a of the wafer transfer robot 39 picks up a wafer W in the wafer storage cassette 37 and mounts it on the surface of each wafer holder 23 (step 101 of Fig. 5). Then the isolation valve 36 is closed and the entire surfaces of all the wafers W are exposed to the ion beam IB to effect ion implantation therein (step 102 of Fig. 5). After completion of the ion implantation for all the wafers W, the isolation valve 36 is opened and the wafers W are dismounted from the respective wafer holders 23 and returned into the wafer storage cassette 37 (step 103 of Fig. 5).

If in the load lock chamber 34 there is a wafer storage cassette 37 with new wafers W to be next subjected to ion implantation, ion implantation is subsequently carried out for the new wafers W (steps 104 → 101 of Fig. 5).

On the other hand, if there is no wafer storage cassette 37 with new wafers W in the load lock chamber 34, the wafer transfer robot 39 picks up a dummy wafer Wd stored in the wafer storage cassette 38 and mounts it on the surface of each wafer holder 23 (step 105 of Fig. 5). Since the dummy wafer covers the surface of each elastic sheet 31 during the period before the wafer W for next ion implantation is mounted on the surface of each wafer holder 23, it can prevent contaminants due to sputtering or the like with the ion bean from attaching to the surface of the elastic sheet 31. After that, the isolation valve 36 is closed.

Then an operator moves all the wafer storage cassettes 37 with the wafers W after the ion implantation to the outside of the load lock chamber 34, then moves wafer storage cassettes 37 with new wafers W into the load lock chamber 34, and places them at the predetermined positions on the cassette mount K. Since at this time the interior of the load lock chamber 34 is exposed to the atmosphere, the inside of the load lock chamber 34 is decompressed to the desired vacuum by the vacuum pump (not shown).

After that, the isolation valve 36 is opened and the wafer transfer robot 39 dismounts the dummy wafers Wd from the respective wafer holders 23 and returns them into the wafer storage cassette 38 (steps 106 → 107 of Fig. 5). Then the new wafers W stored in the wafer storage cassette 37 are mounted on the surfaces of the respective wafer holders 23 and the ion implantation is carried out.

In this embodiment, as described above, the dummy wafers Wd are mounted on the surfaces of the respective wafer holders 23 after the dismounting of the wafers W from the respective wafer holders 23, which can largely decrease the time in which the surfaces of the elastic sheets 31 are in the exposed state, so as to decrease contaminants attaching to the surfaces of the elastic sheets 31. For this reason, when in a next ion implantation process a wafer W is mounted on the surface of each wafer holder 23, the back surface of each wafer W can be kept in contact with the surface of the elastic sheet 31 across the almost entire surface. This yields high thermal conductivity between the elastic sheet 31 and the wafer W, thereby enhancing the cooling efficiency of wafer W with the cooling water flowing in the cooling water path 25 in the heat sink paddle 24.

If after dismounting of the wafers W from the respective wafer holders 23 there are wafers W to be subsequently subjected to ion implantation in the load lock chamber 34, the wafers W immediately mounted on the surfaces of the respective wafer holders 23, whereby the ion implantation process can be performed efficiently.

Although in the present embodiment the scan on the wafers W with the ion beam IB was implemented by the rotation and swing motions of the wafer supporting unit 17, the present invention does not always have to be limited to this particular configuration but can also be applied to ion implantation apparatus of a type moving the ion beam itself, for example.

### Industrial Applicability

Since the present invention reduces the contaminants attaching to the wafer holders during the period between ion implantation and next ion implantation, high thermal conductivity is yielded between each wafer and the respective wafer holder, thus improving the wafer cooling efficiency with cooling water.

As a consequence, the present invention makes it feasible to be ready for enhancement of performance of devices in the fields of fabrication of electromicrodevices such as semiconductor devices and others.

## Claims

1. An ion implantation method of radiating ions to each of wafers held on a plurality of respective wafer holders to implement ion implantation therein,
wherein during a period between an ion implantation process and a next ion implantation process, when the ion radiation is kept on and when a wafer is dismounted from at least one of said plurality of wafer holders, said at least one wafer holder holds a dummy wafer thereon.

2. The ion implantation method according to Claim 1, comprising a first step of making said plurality of respective wafer holders hold the wafers, a second step of implementing the ion implantation in said wafers held on said plurality of wafer holders, and a third step of, after completion of the ion implantation in said wafers, dismounting all the wafers from said plurality of wafer holders, said first to third steps being carried out repeatedly while maintaining said ion radiation, said ion implantation method further comprising a step of making said plurality of respective wafer holders hold dummy wafers during a transfer period from said third step to said first step.

3. The ion implantation method according to Claim 1, comprising a first step of making said plurality of respective wafer holders hold the wafers, a second step of implementing the ion implantation in said wafers held on said plurality of wafer holders, and a third step of, after completion of the ion implantation in said wafers, dismounting said wafers from at least part of said plurality of wafer holders, said first to third steps being carried out repeatedly while maintaining said ion radiation, wherein during a transfer period from said third step to said first step, if there is a wafer to be subsequently subjected to ion implantation said wafer is made to be held on said wafer holder, or if there is no wafer to be subjected to ion implantation said dummy wafer is made to be held on said wafer holder.

4. An ion implantation apparatus comprising:
a target chamber under vacuum inside;
a wafer holder placed in said target chamber;
ion beam generating means for generating an ion beam to be radiated to a wafer held on said wafer holder;
a load lock chamber placed adjacent to said target chamber and kept under vacuum inside;
wafer transfer means for transferring a wafer between said load lock chamber and target chamber; and
control means for controlling said wafer transfer means so as to make said wafer holder hold said wafer before said ion beam generated by said ion beam generating means is radiated to the wafer to implement ion implantation therein, and for controlling said wafer transfer means so as to dismount said wafer from said wafer holder after completion of the ion implantation in said wafer,
wherein said control means controls said wafer transfer means so as to make said wafer holder hold a dummy wafer during a period after said wafer is dismounted from said wafer holder and before a new wafer is held on said wafer holder.

5. The ion implantation apparatus according to Claim 4, further comprising dummy wafer storing means for storing said dummy wafer, which is disposed in said load lock chamber.

6. The ion implantation apparatus according to Claim 4, wherein said control means monitors whether a wafer to be subsequently subjected to ion implantation is present in said load lock chamber after said wafer is dismounted from said wafer holder, wherein when it is determined that said wafer to be subjected to ion implantation is present, the control means controls said wafer transfer means so as to make said wafer holder hold said wafer, and wherein when it is determined that said wafer to be subjected to ion implantation is absent, the control means controls said wafer transfer means so as to make said wafer holder hold the dummy wafer.

7. An ion implantation apparatus for radiating ions to each of wafers held on a plurality of respective wafer holders to implement ion implantation therein,
wherein during a period between an ion implantation process and a next ion implantation process, when a wafer is dismounted from at least one of said plurality of wafer holders, said at least one wafer holder is made to hold a dummy wafer.
